(19) Europäisches Patentamt
European Patent Office
Office européen des brevets

(11) Veröffentlichungsnummer: **0 157 932**
**B1**

(12) **EUROPÄISCHE PATENTSCHRIFT**

(45) Veröffentlichungstag der Patentschrift: **09.03.88**

(51) Int. Cl.⁴: **G 03 F 7/26,** G 03 F 7/10, G 03 C 1/70, C 08 G 73/18, C 08 G 73/20, H 01 L 21/312, H 01 L 21/47

(21) Anmeldenummer: **84115195.4**

(22) Anmeldetag: **12.12.84**

(54) **Verfahren zur Herstellung von Polyimidazol- und Polyimidazopyrrolon-Reliefstrukturen.**

(30) Priorität: **29.03.84 DE 3411714**

(43) Veröffentlichungstag der Anmeldung: **16.10.85 Patentblatt 85/42**

(45) Bekanntmachung des Hinweises auf die Patenterteilung: **09.03.88 Patentblatt 88/10**

(84) Benannte Vertragsstaaten: **AT BE CH DE FR GB IT LI NL SE**

(56) Entgegenhaltungen:
**DE - A - 2 933 819**
**DE - A - 2 933 871**
**DE - A - 3 021 748**
**US - A - 3 574 170**

**L. UND M. FIESER, "Organische Chemie", 1965 VERLAG CHEMIE, Weinheim/Bergstr.**

(73) Patentinhaber: **Siemens Aktiengesellschaft Berlin und München, Wittelsbacherplatz 2, D-8000 München 2 (DE)**

(72) Erfinder: **Ahne, Hellmut, Dr., Heidestrasse 6, D-8551 Röttenbach (DE)**

**EP 0 157 932 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Die Erfindung betrifft ein Verfahren zur Herstellung hochwärmebeständiger Polyimidazol- und Polyimidazopyrrolon-Reliefstrukturen durch Auftragen strahlungsempfindlicher löslicher Polymer-Vorstufen in Form einer Schicht oder Folie auf ein Substrat, Bestrahlen der Schicht bzw. Folie durch Negativvorlagen mit aktinischem Licht oder Elektronen oder durch Führen eines Licht-, Elektronen-, Ionen- oder Laserstrahls, Entfernen der nichtbestrahlten Schicht- bzw. Folienteile und gegebenenfalls durch nachfolgendes Tempern, sowie die Verwendung dieser Reliefstrukturen.

Aus der DE-A-2933871 ist ein Verfahren der eingangs genannten Art zur Herstellung hochwärmebeständiger Polyimidazol- und Polyimidazopyrrolon-Reliefstrukturen bekannt. Bei diesem Verfahren werden als Polymer-Vorstufen Additionsprodukte von olefinisch ungesättigten Monoepoxiden an aminogruppenhaltige Polykondensationsprodukte von aromatischen und/oder heterocyclischen Tetraaminoverbindungen mit Dicarbonsäurechloriden oder -estern bzw. an aminogruppenhaltige Polyadditionsprodukte aus den Tetraaminoverbindungen und Tetracarbonsäuredianhydriden verwendet.

Die nach dem bekannten Verfahren hergestellten Reliefstrukturen zeichnen sich durch besondere Eigenschaften aus. So überstehen sie Ausheizprozesse bis 450°C und sind auch im Dauerbetrieb gegenüber harter Strahlung resistent. Die bekannten Reliefstrukturen sind auch als Masken zur Feinstrukturierung von Substraten auf nasschemischem Weg, beispielsweise durch alkalisches oder saures Ätzen, geeignet. Noch nicht ganz zufriedenstellend sind beim bekannten Verfahren die Verarbeitungseigenschaften der Polymer-Vorstufen, insbesondere ist deren Photoempfindlichkeit begrenzt.

Aufgabe der Erfindung ist es, das Verfahren der eingangs genannten Art zur Herstellung von Polyimidazol- und Polyimidazopyrrolon-Reliefstrukturen dahingehend weiter zu verbessern, dass mit kurzen Belichtungszeiten hochwärmebeständige und sehr reine Reliefstrukturen hergestellt werden können.

Dies wird erfindungsgemäss dadurch erreicht, dass als Polymer-Vorstufen unter Verwendung von Carbodiimiden hergestellte Reaktionsprodukte von aromatischen und/oder heterocyclischen Tetraaminoverbindungen mit olefinisch ungesättigten Monocarbonsäuren und Dicarbonsäuren bzw. entweder mit olefinisch ungesättigten Monocarbonsäuren und aromatischen und/oder heterocyclischen Tetracarbonsäuredianhydriden oder mit olefinisch ungesättigten Tetracarbonsäurediestern in Form von Additionsprodukten aus den Tetracarbonsäuredianhydriden und olefinisch ungesättigten Alkoholen verwendet werden.

Die nach dem erfindungsgemässen Verfahren hergestellten Reliefstrukturen weisen eine ausgezeichnete Temperaturbeständigkeit auf. Darüber hinaus sind diese Reliefstrukturen zum Teil in polaren organischen Lösungsmitteln, wie Dimethylsulfoxid, Dimethylacetamid, Dimethylformamid und N-Methylpyrrolidon, löslich und können deshalb – bei Bedarf – von Substraten auch wieder entfernt werden. Ferner zeichnet sich das erfindungsgemässe Verfahren dadurch aus, dass die verwendeten Polymer-Vorstufen zum Teil in wässrig-alkalischen Medien löslich sind, d.h. dass die strahlungsreaktiven Vorstufen nach der Belichtung wässrig-alkalisch entwickelt werden können. Dies ist insbesondere aus wirtschaftlichen und ökologischen Gründen von Interesse, da die Nachteile organischer Entwickler, wie Brennbarkeit und Toxizität, entfallen. Das erfindungsgemässe Verfahren zeichnet sich darüber hinaus insbesondere auch noch dadurch aus, dass bei relativ kurzen Belichtungszeiten ausserordentlich kantenscharfe Strukturen mit sehr guter Auflösung erhalten werden.

Beim erfindungsgemässen Verfahren können die Polymer-Vorstufen vorteilhaft zusammen mit licht- oder strahlungsempfindlichen copolymerisationsfähigen Verbindungen eingesetzt werden. Dazu werden vorzugsweise N-substituierte Maleinimide verwendet. Es können aber auch acrylat- bzw. methacrylatgruppenhaltige Verbindungen eingesetzt werden. Weiter können auch Photoinitiatoren und/oder -sensibilisatoren verwendet werden (vgl.: «Industrie Chimique Belge», 24, 1959, S. 739 bis 764, sowie J. Kosar, «Light-Sensitive Systems», John Wiley & Sons Inc., New York 1965, S. 143 bis 146 und S. 160 bis 188). Besonders geeignet sind Imidazole, insbesondere Benzimidazole, und Ketocumarine sowie Michlers Keton; es eignen sich beispielsweise aber auch Benzoinether, 2-tert.Butyl-9.10-anthrachinon, 1.2-Benz-9.10-anthrachinon und 4.4'-Bis(diethylamino)-benzophenon. Ferner können beim erfindungsgemässen Verfahren vorteilhaft Haftvermittler verwendet werden. Dazu dienen insbesondere Silane, wie Vinyltriethoxysilan, Vinyl-tris(β-methoxyethoxy)-silan, γ-Methacryloxy-propyl-trimethoxysilan und γ-Glycidoxy-propyl-trimethoxysilan.

Die beim erfindungsgemässen Verfahren eingesetzten strahlungsreaktiven Vorstufen, die oligomerer und/oder polymerer Natur sind, sind in der gleichzeitig eingereichten europäischen Patentanmeldung «Verfahren zur Herstellung von Polyimidazol- und Polyimidazopyrrolon-Vorstufen», Anmeldenummer 841151947 (EP-A-0157931) beschrieben. Diese Vorstufen weisen im allgemeinen folgende Struktur auf:

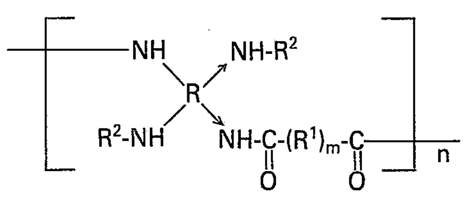

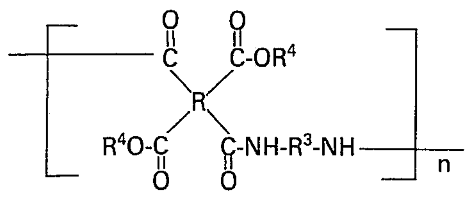

Mit den in den Formeln, die erste Formel steht dabei für Polyimidazol-Vorstufen und die zweite Formel für Polyimidazopyrrolon-Vorstufen, enthaltenen Pfeilen soll die Tatsache zum Ausdruck gebracht werden, dass die beiden fraglichen Substituenten an R ihre Stellung vertauschen können. Dies ist deshalb von Bedeutung, weil es sich bei R, wie nachfolgend noch erläutert wird, um einen cyclischen Rest handelt.

In den Formeln bedeutet n eine ganze Zahl von 2 bis etwa 100 und m ist 0 oder 1. Für R, $R^1$, $R^2$, $R^3$ und $R^4$ gilt folgendes:

R ist ein – gegebenenfalls halogenierter – zumindest partiell aromatischer und/oder heterocyclischer tetravalenter, d. h. tetrafunktioneller Rest, bei dem jeweils zwei Valenzen in Nachbarstellung zueinander angeordnet sind; weist der Rest R mehrere aromatische und/oder heterocyclische Strukturelemente auf, so befinden sich die Valenzpaare jeweils an endständigen derartigen Strukturelementen;

$R^1$ ist ein – gegebenenfalls halogenierter – divalenter, d. h. difunktioneller Rest aliphatischer und/oder cycloaliphatischer, gegebenenfalls Heteroatome aufweisender, und/oder aromatischer und/oder heterocyclischer Struktur;

$R^2$ ist ein olefinisch ungesättigter Rest, beispielsweise eine allyletherhaltige Gruppe, insbesondere eine – gegebenenfalls substituierte – (meth)acrylesterhaltige Gruppe oder eine Propargylgruppe;

$R^3$ ist ein zumindest partiell aromatischer und/oder heterocyclischer divalenter, d. h. difunktioneller Rest, bei dem wenigstens zu einer der beiden Valenzen in Nachbarstellung eine Aminogruppe angeordnet ist; weist $R^3$ mehrere aromatische und/oder heterocyclische Strukturelemente auf, so befinden sich die freien Valenzen jeweils an endständigen derartigen Strukturelementen;

$R^4$ ist Wasserstoff oder $R^2$.

Die Herstellung der erfindungsgemässen Reliefstrukturen erfolgt, wie bereits ausgeführt, in der Weise, dass die Polymer-Vorstufe in Form einer Schicht oder Folie auf ein Substrat aufgebracht und mit aktinischem Licht oder mit Elektronen durch eine Maske belichtet oder durch Führen eines Licht-, Elektronen-, Ionen- oder Laserstrahls bestrahlt wird; anschliessend werden die nichtbelichteten bzw. nichtbestrahlten Schicht- oder Folienteile herausgelöst oder abgezogen und die dabei erhaltenen Reliefstrukturen werden gegebenenfalls getempert. Die Vorstufe kann vorteilhaft in einem organischen Lösungsmittel gelöst auf das Substrat aufgebracht werden; vorzugsweise wird als Lösungsmittel N-Methylpyrrolidon verwendet. Die Konzentration der Lösung kann so eingestellt werden, dass mit bekannten Beschichtungsverfahren, wie Schleudern, Tauchen, Sprühen, Bürsten oder Rollen, Schichtstärken von 0,01 µm bis einige 100 µm erzeugt werden können. Es hat sich gezeigt, dass beispielsweise beim Schleuderbeschichten 300 bis 10000 Umdrehungen pro Minute für die Dauer von 1 bis 100 s geeignet sind, um eine gleichmässige und gute Oberflächenqualität zu erzielen. Die auf das Substrat, das vorzugsweise aus Glas, Metall, Kunststoff oder halbleitendem Material besteht, aufgebrachte Photoresistschicht kann bei Raumtemperatur oder bei erhöhter Temperatur, vorzugsweise bei einer Temperatur von 20 bis 50°C, in einem Stickstoff- oder Luftstrom vom Lösungsmittel befreit werden; dabei kann vorteilhaft auch im Vakuum gearbeitet werden.

Zur Erzielung eines ausreichenden Löslichkeitsunterschiedes zwischen den bestrahlten und den nichtbestrahlten Schicht- bzw. Folienteilen genügen beim erfindungsgemässen Verfahren – bei der Verwendung einer 500 W-Quecksilberhöchstdrucklampe – in Abhängigkeit von der Zusammensetzung und der Schichtstärke Belichtungszeiten zwischen 10 und 600 s. Nach dem Belichten werden die nichtbelichteten Teile der Schicht bzw. Folie herausgelöst, vorzugsweise wässrig-alkalisch oder auch mit einem organischen Entwickler.

Mittels des erfindungsgemässen Verfahrens werden konturenscharfe Bilder, d. h. Reliefstrukturen, erhalten, die durch Temperung in hochwärmebeständige, gegenüber Säuren und Laugen resistente Polymere umgewandelt werden. Im allgemeinen können Temperaturen von 220 bis 500°C gewählt werden, vorzugsweise wird bei Temperaturen von 300 bis 400°C getempert. Die Temperzeit beträgt im allgemeinen eine halbe Stunde, wobei unter Stickstoff keine Verfärbung zu beobachten ist. Die Kantenschärfe und die Massgenauigkeit der Reliefstrukturen werden durch die Temperung praktisch nicht beeinträchtigt. Darüber hinaus bleibt die gute Oberflächenqualität der Reliefstrukturen trotz eines beim Tempern eintretenden Schichtstärkenverlustes erhalten.

Beim erfindungsgemässen Verfahren werden vorzugsweise Polymer-Vorstufen aus aromatischen Komponenten eingesetzt, so dass bei der thermischen Behandlung, d. h. bei der Temperung, Polymere mit folgenden Struktureinheiten gebildet werden:

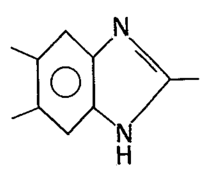

Polyimidazol

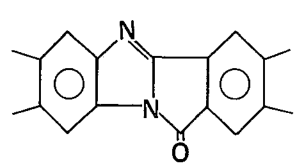

Polyimidazopyrrolon

Die genannten Verbindungsklassen zählen zu den Halb-Leiterpolymeren bzw. Leiterpolymeren und zeichnen sich durch eine hohe Temperaturbeständigkeit aus (bis zu ca. 500°C).

Die Herstellung von Polyimidazol-Vorstufen erfolgt im übrigen im allgemeinen in der Weise, dass eine Tetraaminoverbindung entweder zunächst mit einer olefinisch ungesättigten Monocarbonsäure umgesetzt und das dabei gebildete Kondensationsprodukt dann mit einer Dicarbonsäure polykondensiert wird oder dass die Tetraaminoverbindung zunächst mit der Dicarbonsäure umgesetzt und an das dabei gebildete Polykondensationsprodukt dann die olefinisch ungesättigte Monocarbonsäure ankondensiert wird. Jede

dieser Umsetzungen wird dabei in Gegenwart von Carbodiimid durchgeführt.

Zur Herstellung von Polyimidazopyrrolon-Vorstufen wird eine Tetraaminoverbindung entweder zunächst in Gegenwart von Carbodiimid mit einer olefinisch ungesättigten Monocarbonsäure umgesetzt und das dabei gebildete Kondensationsprodukt dann an ein Tetracarbonsäuredianhydrid polyaddiert oder die Tetraaminoverbindung wird zunächst mit dem Tetracarbonsäuredianhydrid umgesetzt und an das dabei gebildete Polyadditionsprodukt – in Gegenwart von Carbodiimid – dann die olefinisch ungesättigte Monocarbonsäure ankondensiert. Eine weitere Möglichkeit zur Herstellung von Polyimidazopyrrolon-Vorstufen besteht darin, die Tetraaminoverbindung – in Gegenwart von Carbodiimid – mit einem olefinisch ungesättigten Tetracarbonsäurediester umzusetzen.

Die beim erfindungsgemässen Verfahren eingesetzten strahlungsreaktiven Vorstufen sind im wesentlichen Polykondensationsprodukte von Tetraaminoverbindungen mit Dicarbonsäuren (Polyimidazol-Vorstufen) bzw. Polyadditionsprodukte aus den Tetraaminoverbindungen und Tetracarbonsäuredianhydriden und Polykondensationsprodukte aus den Tetraaminoverbindungen und Tetracarbonsäurediestern (Polyimidazopyrrolon-Vorstufen). Als Tetraaminoverbindung wird dabei Diaminobenzidin bevorzugt. Die bevorzugt eingesetzte Dicarbonsäure ist Isophthalsäure und das bevorzugte Tetracarbonsäuredianhydrid Pyromellithsäuredianhydrid. Bei der Herstellung der Vorstufen werden ferner ungesättigte Monocarbonsäuren eingesetzt, wobei Acrylsäure und Methacrylsäure bevorzugt werden. Unter den ebenfalls zum Einsatz gelangenden ungesättigten Alkoholen finden insbesondere Hydroxyethylacrylat und Hydroxyethylmethacrylat Verwendung. Von den zur Herstellung der Vorstufen benötigten Carbodiimiden wird Dicyclohexylcarbodiimid bevorzugt; Carbodiimide sind im übrigen Verbindungen vom Typ R'-N=C=N-R".

Die erfindungsgemässen Reliefstrukturen können zur Herstellung von Passivierungsschichten auf Halbleiterbauelementen, von Dünn- und Dickfilmschaltungen, von Lötschutzschichten auf Mehrlagenschaltungen, von Isolierschichten als Bestandteil von Schichtschaltungen und von miniaturisierten Schutz- und Isolierschichten auf elektrisch leitenden und/oder halbleitenden und/oder isolierenden Basismaterialien, insbesondere im Bereich der Mikroelektronik oder allgemein für die Feinstrukturierung von Substraten, Anwendung finden. Vorzugsweise dienen die hochwärmebeständigen Reliefstrukturen als Masken für Nass- und Trockenätzprozesse, stromlose oder galvanische Metallabscheidung und Aufdampfverfahren sowie als Masken für die Ionenimplantation, darüber hinaus als Isolier- und Schutzschichten in der Elektrotechnik. Reliefstrukturen auf der Basis von Polyimidazolen können dabei vorteilhaft dann eingesetzt werden, wenn die Reliefstruktur eine intermediäre Schutzfunktion ausüben soll; diese Reliefstrukturen sind nämlich in polaren Lösungsmitteln löslich und können deshalb leicht wieder entfernt werden. Ferner können die erfindungsgemässen Reliefstrukturen vorteilhaft als Orientierungsschichten, beispielsweise in Flüssigkristalldisplays, sowie zur Rasterung von Oberflächen, beispielsweise bei Röntgenschirmen, insbesondere Röntgenbildverstärkern, verwendet werden.

Anhand von Ausführungsbeispielen soll die Erfindung noch näher erläutert werden.

Beispiel 1

Herstellung einer strahlungsreaktiven Polybenzimidazol-Vorstufe

21,4 Gewichtsteile Diaminobenzidin (0,1 Mol) und 16 Gewichtsteile Methacrylsäure (0,19 Mol) werden in 70 Volumenteilen N-Methylpyrrolidon gelöst. Unter Rühren und Kühlung auf 10°C werden zu dieser Lösung dann 42 Gewichtsteile Dicyclohexylcarbodiimid (0,2 Mol) in 100 Volumenteilen γ-Butyrolacton zugetropft. Nach beendeter Zugabe bleibt die Reaktionslösung noch 3 h bei Raumtemperatur stehen. Danach werden zur Reaktionslösung 16,6 Gewichtsteile Isophthalsäure gegeben und anschliessend wird – unter Rühren und Kühlung auf 8°C – eine Lösung von 42 Gewichtsteilen Dicyclohexylcarbodiimid (0,2 Mol) in 120 Volumenteilen γ-Butyrolacton langsam zugetropft. Dabei bildet sich bald eine viskose Harzlösung, die bei Raumtemperatur 18 h stehengelassen wird. Nachfolgend wird der Dicyclohexylharnstoff abfiltriert, wobei eine klare Harzlösung erhalten wird.

Herstellung einer Reliefstruktur

Zu 20 ml der erhaltenen Harzlösung werden 0,1 g Michlers Keton und 0,3 g N-Phenylmaleinimid gegeben. Mittels einer Schleuder wird daraus auf einem Aluminiumblech eine homogene Schicht hergestellt, die nachfolgend bei einer Temperatur von 30°C und einem Druck von $0,5 \times 10^4$ Pa getrocknet wird. Bei einer Belichtungszeit von 60 s durch eine Maske (mittels einer 500 W-Quecksilberhöchstdrucklampe) und bei einer Sprühentwicklung mit γ-Butyrolacton für die Dauer von 20 s werden Reliefstrukturen erhalten, die durch Tempern bei einer Temperatur von 400°C (Dauer: 30 min) in Polybenzimidazol-Reliefstrukturen umgewandelt werden können. Bei einer Schichtdicke von 3 μm werden noch Strukturen von 5 μm gut aufgelöst.

Beispiel 2

Herstellung einer strahlungsreaktiven Polyimidazopyrrolon-Vorstufe

Zu 21,8 Gewichtsteilen Pyromellithsäuredianhydrid (0,1 Mol) in 50 Volumenteilen N-Methylpyrrolidon werden unter Rühren und Feuchtigkeitsausschluss 26 Gewichtsteile Hydroxyethylmethacrylat (0,2 Mol) gegeben. Die Reaktionsmischung wird dann 20 h bei Raumtemperatur stehengelassen. Der titrimetrisch ermittelte Carboxylgehalt beträgt 0,21 Mol/100 g. Unter Rühren wird zur Reaktionslösung dann eine Lösung von 20,4 Gewichtsteilen Diaminobenzidin (0,09 Mol) in 70 Volumenteilen N-Methylpyrrolidon gegeben. Anschliessend wird zu der auf eine Temperatur von 5 bis 10°C gekühlten Lösung eine Lösung von 42 Gewichtsteilen Dicyclohexylcarbodiimid (0,2 Mol) in 120 Volumenteilen γ-Butyrolacton zugetropft. Nach beendeter Zugabe wird die viskose Reaktionslösung bei Raumtemperatur 20 h stehengelassen und danach durch Filtration vom ausgefallenen Dicyclohexylharnstoff befreit. Beim Eintropfen der Harzlösung in destilliertes Wasser unter Rühren fällt eine gelbe Festsubstanz aus, die nach dem Trocknen bei einer Temperatur von 40°C und einem Druck von $1,3 \times 10^4$ Pa ein gelbes Harzpulver ergibt. Im IR-Spektrum sind die für Methacrylate typischen Absorptionen bei 950 und 1630 $cm^{-1}$ vorhanden.

Herstellung der Reliefstruktur

10 Gewichtsteile der auf die vorstehend beschriebene Weise als Festharz isolierten Polyimidazopyrrolon-Vorstufe werden zusammen mit 0,2 Gewichtsteilen Michlers Keton und 0,2 Gewichtsteilen Azidosulfonylphenylmaleinimid in 17 Volumenteilen N-Methylpyrrolidon gelöst und dann mit 0,1 Gewichtsteilen Vinyltris(β-methoxyethoxy)-silan versetzt. Nach einer Druckfiltration durch ein 0,8 μm-Filter werden auf einem Siliciumwafer durch Schleudern 2 μm dicke Schichten erzeugt. Bei einer Bestrahlung durch eine Kontaktmaske mit einer 350 W-Quecksilberhöchstdrucklampe und bei einer Entwicklung mit N-Methylpyrrolidon für die Dauer von 20 s werden feine Reliefstrukturen erhalten, die durch Erhitzen auf eine Temperatur von 420°C (Dauer: 30 min) in hochwärmebeständige Polyimidazopyrrolon-Reliefstrukturen umgewandelt werden können.

**Patentansprüche**

1. Verfahren zur Herstellung hochwärmebeständiger Polyimidazol- und Polyimidazopyrrolon-Reliefstrukturen durch Auftragen strahlungsempfindlicher löslicher Polymer-Vorstufen in Form einer Schicht oder Folie auf ein Substrat, Bestrahlen der Schicht bzw. Folie durch Negativvorlagen mit aktinischem Licht oder Elektronen oder durch Führen eines Licht-, Elektronen-, Ionen- oder Laserstrahls, Entfernen der nichtbestrahlten Schicht- bzw. Folienteile und gegebenenfalls durch nachfolgendes Tempern, dadurch gekennzeichnet, dass als Polymer-Vorstufen unter Verwendung von Carbodiimiden hergestellte Reaktionsprodukte von aromatischen und /oder heterocyclischen Tetraaminoverbindungen

a) mit olefinisch ungesättigten Monocarbonsäuren und Dicarbonsäuren bzw.

b) entweder mit olefinisch ungesättigten Monocarbonsäuren und aromatischen und/oder heterocyclischen Tetracarbonsäuredianhydriden oder mit olefinisch ungesättigten Tetracarbonsäurediestern in Form von Additionsprodukten aus den Tetracarbonsäuredianhydriden und olefinisch ungesättigten Alkoholen

verwendet werden.

2. Verfahren nach Anspruch 1, dadurch gekennzeichnet, dass die Polymer-Vorstufen zusammen mit licht- oder strahlungsempfindlichen copolymerisationsfähigen Verbindungen eingesetzt werden, insbesondere mit N-substituierten Maleinimiden.

3. Verfahren nach Anspruch 1 oder 2, dadurch gekennzeichnet, dass die Polymer-Vorstufen zusammen mit Photoinitiatoren und/oder Photosensibilisatoren eingesetzt werden, insbesondere mit Michlers Keton, Benzimidazolen und/oder Ketocumarinen.

4. Verfahren nach einem der Ansprüche 1 bis 3, dadurch gekennzeichnet, dass Haftvermittler, insbesondere Silane, verwendet werden.

5. Verfahren nach einem oder mehreren der Ansprüche 1 bis 4, dadurch gekennzeichnet, dass ein Polykondensationsprodukt von Isophthalsäure mit einem in Gegenwart von Carbodiimid hergestellten Kondensationsprodukt von Acrylsäure oder Methacrylsäure und Diaminobenzidin verwendet wird.

6. Verfahren nach einem oder mehreren der Ansprüche 1 bis 4, dadurch gekennzeichnet, dass ein Polykondensationsprodukt von Diaminobenzidin mit einem Additionsprodukt von Hydroxyethylacrylat oder Hydroxyethylmethacrylat an Pyromellithsäureanhydrid verwendet wird.

7. Verwendung der nach dem Verfahren nach einem oder mehreren der Ansprüche 1 bis 6 hergestellten Reliefstrukturen als Resist mit intermediärer Schutzfunktion zur lithographischen Strukturierung von Oberflächen, insbesondere bei Trocken- und Nassätzverfahren.

8. Verwendung der nach dem Verfahren nach einem oder mehreren der Ansprüche 1 bis 6 hergestellten Reliefstrukturen zur dauerhaften Beschichtung oder Rasterung von Oberflächen.

9. Verwendung der nach dem Verfahren nach einem oder mehreren der Ansprüche 1 bis 6 hergestellten Reliefstrukturen als Schutz- und Isolierstoff in der Elektrotechnik.

**Claims**

1. A process for the production of highly heat-resistant polyimidazole and polyimidazopyrrolone relief structures by the application of radiation-sensitive, soluble polymer precursors in the form of a layer or film onto a substrate, irradiation of the layer or film through negative patterns with actinic light, or electrons, or by the guiding of a beam of light, electrons, or ions, or a laser beam, removal of the parts of the sheet or film which are not irradiated and, if necessary, subsequent annealing, characterised in that as polymer precursors, there are used reaction products, produced using carbodiimides, of aromatic and/or heterocyclic tetra-amino compounds

a) with olefinically-unsaturated monocarboxylic acids and dicarboxylic acids, or

b) either with olefinically-unsaturated monocarboxylic acids and aromatic and/or heterocyclic tetracarboxylic acid dianhydrides or with olefinically-unsaturated tetracarboxylic acid diesters, in

the form of addition products of the tetracarboxylic acid dianhydrides and olefinically-unsaturated alcohols.

2. A process as claimed in Claim 1, characterised in that the polymer precursors are used together with light-sensitive or radiation-sensitive compounds which are capable of co-polymerisation, in particular, with N-substituted maleic acid imides.

3. A process as claimed in Claim 1 or 2, characterised in that the polymer precursors are used together with photo-initiators and/or photo-sensitisers, in particular with Michler's ketone, benzimidazoles and/or keto coumarins

4. A process as claimed in one of Claims 1 to 3, characterised in that adhesives, particularly silanes are used.

5. A process as claimed in one or more of Claims 1 to 4, characterised in that a poly-condensation product of isophthalic acid is used with a condensation product of acrylic acid or methacrylic acid and diaminobenzidine, produced in the presence of carbodiimide.

6. A process as claimed in one or more of Claims 1 to 4, characterised in that a poly-condensation product of diaminobenzidine with an addition product of hydroxyethyl acrylate or hydroxyethyl methacrylate and pyromellitic acid anhydride, is used.

7. The use of relief structures produced according to the process as claimed in one or more of Claims 1 to 6, as a resist having an intermediary protective function in the lithographic structuring of surfaces, in particular in dry and wet etching processes.

8. The use of relief structures produced according to the process as claimed in one or more of Claims 1 to 6, for the permanent coating or embossing of surfaces.

9. The use of relief structures produced according to the process as claimed in one or more of Claims 1 to 6, as a protective and insulating material in electrical engineering.

**Revendications**

1. Procédé de préparation de structures en relief très résistantes à la chaleur, en polyimidazole et en polyimidazopyrrolone, par dépôt de précurseurs de polymère, solubles et sensibles à un rayonnement, sous la forme d'une couche ou d'une feuille sur un substrat, par exposition de la couche ou de la feuille à travers un original négatif, à de la lumière actinique ou à des électrons ou par l'envoi d'un faisceau de lumière, d'électrons, d'ions ou de laser, par élimination des parties de la couche ou de la feuille qui n'ont pas été exposées et, éventuellement, par un traitement thermique subséquent, caractérisé en ce qu'il consiste à utiliser comme précurseurs de polymère des produits de réaction, préparés en utilisant des carbodimides, de composés tétraaminés, aromatiques et/ou hétérocycliques,

a) sur des acides monocarboxyliques à insaturation oléfinique et des acides dicarboxyliques et

b) soit sur des acides monocarboxyliques à insaturation oléfinique et des dianhydrides d'acide tétracarboxylique aromatiques et/ou hétérocycliques soit sur des diester d'acide tétracarboxylique à insaturation oléfinique sous forme de produit d'addition de dianhydrides d'acide tétracarboxylique et d'alcools à insaturation oléfinique.

2. Procédé suivant la revendication 1, caractérisé en ce qu'il consiste à mettre en œuvre les précurseurs de polymère en même temps que des composés copolymérisables sensibles à la lumière ou au rayonnement, notamment des maléimides à substitution sur l'azote.

3. Procédé suivant la revendication 1 ou 2, caractérisé en ce qu'il consiste à mettre en œuvre les précurseurs de polymère en même temps que des photoinitiateurs et/ou des photosensibilisateurs, notamment la cétone de Michler, des benzimidazoles et/ou des cétocoumarines.

4. Procédé suivant l'une des revendications 1 à 3, caractérisé en ce qu'il consiste à utiliser des agents de pontage, notamment des silanes.

5. Procédé suivant l'une ou plusieurs des revendications 1 à 4, caractérisé en ce qu'il consiste à utiliser un produit de polycondensation d'acide isophtalique et d'un produit de condensation, préparé en présence de carbodiimide, de l'acide acrylique ou de l'acide méthacrylique et de la diaminobenzidine.

6. Procédé suivant l'une ou plusieurs des revendications 1 à 4, caractérisé en ce qu'il consiste à utiliser un produit de polycondensation de diaminobenzidine et d'un produit d'addition d'acrylate d'hydroxyéthyle ou de méthacrylate d'hydroxyéthyle sur l'anhydride d'acide pyromellitique.

7. Utilisation des structures en relief préparées par le procédé suivant l'une ou plusieurs des revendications 1 à 6 comme résist, à fonction intermédiaire de protection pour la structuration lithographique de surfaces, notamment dans des procédés de gravure par voie sèche et par voie humide.

8. Utilisation des structures en relief préparées par le procédé suivant l'une ou plusieurs des revendications 1 à 6, pour le revêtement permanent ou pour le tramage de surface.

9. Utilisation de structures en relief préparées par le procédé suivant l'une ou plusieurs des revendications 1 à 6 comme matériau de protection et isolant en électrotechnique.